# EUROPÄISCHE PATENTANMELDUNG

(11) **EP 2 597 681 A1**
(43) Veröffentlichungstag der Anmeldung: **29.05.2013**
(21) Anmeldenummer: 11190068.4
(22) Anmeldetag: 22.11.2011
(51) Int. Cl.: H01L 31/0216, H01L 31/0232, G02B 1/11, G02B 5/02

(54) **Schutzschicht für Photovoltaikmodule, sowie Verfahren zu deren Herstellung**

(71) Anmelder: Holtmann & Stierle Chemie GmbH, 32130 Enger (DE)
(72) Erfinder: Holtmann, Alexander, 32257 Bünde (DE)
(74) Vertreter: Ter Meer Steinmeister & Partner

(57) **Zusammenfassung**

Schutzschicht für Photovoltaikmodule, gekennzeichnet durch eine Schicht (10) aus einem transparenten Polymer, die mit flachen Glaspartikeln (16) durchsetzt ist, welche im wesentlichen parallel zur Schichtoberfläche ausgerichtet sind, wobei dem Polymer ferner ein Bindemittel zugesetzt ist.

## Beschreibung

Die vorliegende Erfindung betrifft eine Schutzschicht für Photovoltaikmodule, sowie ein Verfahren zur Herstellung einer solchen Schutzschicht.

Photovoltaikmodule werden schon seit geraumer Zeit zur Stromerzeugung eingesetzt und kontinuierlich weiterentwickelt. Da der Anschaffungspreis solcher Module vergleichsweise hoch ist, spielen die Effizienz und die Haltbarkeit der Module eine große Rolle. Es ist bekannt, dass Photovoltaikmodule einem gewissen Alterungsprozess unterliegen, der die Effizienz der Stromerzeugung langfristig sinken lässt. Unter anderem wird die Effizienz durch Beeinträchtigungen der Oberfläche der Module gemindert, beispielsweise durch Verschmutzung, Witterungseinflüsse und dergleichen.

Um die Haltbarkeit der Module zu steigern und ihre Lebensdauer zu verlängern, können sie mit einer transparenten Schutzschicht auf ihrer freien Oberfläche versehen werden. Diese lässt das Sonnenlicht durch, also insbesondere die Wellenlängen, die zur Erzeugung des Solarstroms beitragen. Beispielsweise wird eine solche Schutzschicht aus einem Kunststoffmaterial gebildet, das auf die Module aufgetragen wird.

Die Effizienz der Module wird jedoch auch durch ihre Winkelstellung zur Sonne beeinflusst. Aus Kostengründen sind die Module in der Regel fest installiert und so ausgerichtet, dass sie beispielsweise bei einem relativ hohen Sonnenstand ausreichend Strom produzieren. Steht die Sonne sehr flach, etwa in den Morgen- oder Abendstunden und in der Wintersaison, wird ein großer Teil des Sonnenlichts an ihrer Oberfläche reflektiert, bedingt durch die bei einem sehr flachen Einfallswinkel auftretende Reflexion an der Oberfläche. Nur ein geringer Teil des Lichts gelangt dann noch auf die im Modul enthaltenen Solarzellen. Im Ergebnis sind fest installierte Photovoltaikmodule also nur zu bestimmten Tages- bzw. Jahreszeiten ausreichend effizient. Maßnahmen zur Beseitigung dieses Missstands, wie etwa eine Nachführung der Module, sind zu teuer und zu aufwendig.

Es ist daher eine Aufgabe der vorliegenden Erfindung, eine Schutzschicht für Photovoltaikmodule zu schaffen, die nicht nur die Lebensdauer des Moduls durch Schutz seiner Oberfläche verlängert, sondern seine Effizienz auch unter ungünstigen Betriebsbedingungen wie etwa einem flachen Einfallswinkel der Sonnenstrahlen gewährleistet.

Diese Aufgabe wird erfindungsgemäß durch eine Schutzschicht mit den Merkmalen des Anspruchs 1 gelöst.

Die erfindungsgemäße Schutzschicht wird im wesentlichen durch ein transparentes Polymer gebildet, das mit flachen Glaspartikeln durchsetzt ist. Diese Partikel oder Chips sind in der Polymermasse bis zur freien Oberfläche der Schicht verteilt. Der Ausdruck ,,flach" soll hierbei bezeichnen, dass die Dicke der Partikel im Vergleich zu ihrer Längen- und/oder Breitenausdehnung relativ gering ist. Die flachen Glaspartikel liegen so in der Polymerschicht ein, dass sie im wesentlichen parallel zur Schichtoberfläche liegen und sich damit etwa in der Schichtungsrichtung erstrecken. Diese Ausrichtung lässt sich durch ein Bindemittel erreichen, dass dem Polymer zugesetzt ist und den Oberflächenwiderstand der Glaspartikel senkt. Wird die flüssige Polymermasse mit den Glaspartikeln aufgetragen, so richten sich die Partikel in der vorstehend beschriebenen Weise von selbst aus und legen sich flach in die Schichtungsrichtung. Die Schicht kann anschließend aushärten.

Fällt ein Lichtstrahl auf die Oberfläche dieser Schutzschicht, wird er durch die Glaspartikel an der Schichtoberfläche bevorzugt in das Innere der Schicht hinein gebrochen bzw. gestreut. Weitere Glaspartikel leiten das gestreute Licht weiter nach unten bis zum Photovoltaikmodul. Dieser Effekt tritt auch bei einem sehr flachen Einfallswinkel des Lichtstrahls auf, bei welchem bei bisherigen Photovoltaikmodulen bzw. herkömmlichen Schutzschichten der größte Teil des Lichts an der Schichtoberfläche reflektiert würde.

Der vorstehend beschriebene Brechungs- oder Streueffekt führt somit dazu, dass auch sehr flach auf das Photovoltaikmodul einfallendes Licht durch die erfindungsgemäße Schutzschicht zum Modul selbst geleitet wird und dort zur Solarstromerzeugung beiträgt. Im Vergleich zu herkömmlichen Modulen weisen Photovoltaikmodule, die mit der erfindungsgemäßen Schutzschicht versehen sind, auch bei sehr flachen Sonnenständen eine hohe Effizienz auf. Die Gesamteffizienz des Moduls, bezogen auf seine Betriebsdauer, wird somit gesteigert, und die Solaranlage kann wirtschaftlicher betrieben werden, ohne dass aufwendige Maßnahmen wie etwa Nachfüllungseinrichtungen für die Module installiert werden müssen.

Gemäß einer bevorzugten Ausführungsform der Erfindung sind die Glaspartikel in einer Konzentration von etwa 10 Gew.-% im Polymer vorhanden.

Gemäß einer weiteren bevorzugten Ausführungsform sind die Glaspartikel in unterschiedlichen Größen gemäß einer vorgegebenen Größenverteilung im Polymer vorhanden. Diese Größenverteilung kann durch eine Siebung der Partikel erreicht werden.

Weiter vorzugsweise weisen die Glaspartikel eine Dicke von 2 - 3 µm auf.

Gemäß einer weiteren bevorzugten Ausführungsform ist das Bindemittel ein einkomponentiges flüssigkeitshärtendes Isocyanat, dem Oberflächenadditive zur Senkung des Oberflächenwiderstands der Glaspartikel zugesetzt sind.

Ein erfindungsgemäßes Verfahren zur Herstellung einer Schutzschicht für Photovoltaikmodule gemäß der vorstehend beschriebenen Art umfasst die folgenden Schritte:
a) Bereitstellung eines flüssigen aushärtbaren Polymers, das zumindest in ausgehärteter Form transparent ist,
b) Einbringen flacher Glaspartikel in das flüssige Polymer,
c) Einbringen eines flüssigen Bindemittels, dem Oberflächenadditive zur Senkung des Oberflächenwiderstands der Glaspartikel zugesetzt sind, in das flüssige Polymer,
d) Auftragen der durch die Schritte a), b) und c) hergestellten Polymermasse auf einen Untergrund zur Bildung einer Schicht,
e) Aushärten der Schicht.

Zunächst werden also die flachen Glaspartikel in geeigneter Konzentration sowie das flüssige Bindemittel mit den Oberflächenadditiven in das flüssige Polymer gemischt, und die so entstandene Polymermasse wird auf einem Untergrund verteilt, so dass eine feste Schicht aushärten kann, die die gewünschten Eigenschaften aufweist.

Bevorzugte Ausführungsformen dieses Verfahrens ergeben sich aus den Unteransprüchen 7 bis 13. Insbesondere wird die Polymermasse bevorzugt unmittelbar auf die Oberfläche des Photovoltaikmoduls aufgetragen, beispielsweise durch Aufsprühen, Aufspritzen oder Aufstreichen. Zur Erleichterung dieser Verarbeitung kann die Polymermasse eine geringe Viskosität aufweisen.

Im folgenden wird ein bevorzugtes Ausführungsbeispiel der Erfindung anhand Zeichnung näher erläutert.

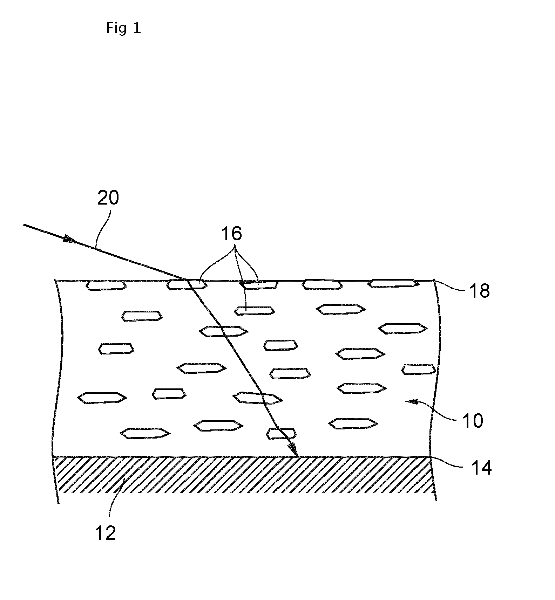

Die einzige Figur zeigt einen schematischen Querschnitt durch eine Ausführungsform der erfindungsgemäßen Schutzschicht für Photovoltaikmodule.

Die Figur zeigt eine Schutzschicht 10 auf einem Photovoltaikmodul 12, dessen Oberfläche 14 lediglich schematisch dargestellt ist. Die Schutzschicht 10 hat über die gesamte Oberfläche des Moduls 12 eine im wesentlichen homogene Dicke. Sie wird gebildet durch eine Schicht aus einem transparenten Polymer, das in flüssiger Form auf die Oberfläche 14 des Photovoltaikmoduls 12 aufgetragen wird und dort aushärtet. Das Polymer ist mit flachen Glaspartikeln 16 durchsetzt, von denen lediglich einige in der Figur stellvertretend mit einer Bezugsziffer versehen sind.

Die Dicke dieser Glaspartikel 16 ist wesentlich geringer als ihre Breite und Höhe und liegt in der Größenordnung von 2 - 3 *µ*m. Die Glaspartikel 16 sind so in der Polymermasse ausgerichtet, dass sie im wesentlichen parallel zur Schichtoberfläche 18 stehen. Im Rahmen der vorliegenden Erfindung ist keine exakt parallele Ausrichtung erforderlich, sondern es sind auch leichte Winkelabweichungen von der parallelen Stellung möglich, so dass die Partikel etwas geneigt zur Oberfläche stehen. Bei den Glaspartikeln 16 handelt es sich um flache Chips, die durch Mahlen und Sieben eines Glasmaterials in unterschiedlichen Größen in der Polymermasse vorhanden sind. Es kann eine vorgegebene Größenverteilung der Glaspartikel 16 durch eine entsprechende Siebung erreicht werden.

Die Konzentration der Glaspartikel 16 in der Polymermasse beträgt etwa 10 Gewichts-%. Die Zeichnung gibt nicht die tatsächlichen Größenverhältnisse zwischen Schichtdicke und Größe der Glaspartikel 16 wieder, sondern dient lediglich zur Erläuterung des Erfindungsgedankens. Die Glaspartikel 16 sind insbesondere nicht in einer dichten Packung angeordnet, in der sie einander berühren, sondern zwischen den Partikeln 16 bestehen Zwischenräume, die durch die Polymermasse ausgefüllt werden. Das Polymer dient also gewissermaßen als Matrix, in welche die Glaspartikel 16 eingebettet sind. Der Brechungsindex des Glasmaterials, aus dem die Partikel 16 bestehen, ist im vorliegenden Fall höher als derjenige des Polymers der umgebenden Matrix.

Um die flache Ausrichtung der Glaspartikel 16 in der Schicht 10 zu erreichen, ist dem Polymer ein Bindemittel zugesetzt. Bei diesem handelt es sich um ein einkomponentiges flüssigkeitshärtendes Isocyanat, welchem Oberflächenadditive zur Senkung des Oberflächenwiderstands der Glaspartikel 16 zugesetzt sind. Durch die Senkung des Oberflächenwiderstands legen sich die Glaspartikel 16 beim Auftragen des flüssigen Polymers flach in die Schicht 10. Nach dem Aushärten der Schicht 10 bleibt diese Ausrichtung erhalten.

Die Verteilung der Glaspartikel 16 in der Schicht 10 ist im vorliegenden Ausführungsbeispiel weitgehend homogen. Insbesondere ist zu gewährleisten, dass die Schicht 10 bis zu ihrer Oberfläche 18 mit den Glaspartikeln 16 durchsetzt ist. Es ist allerdings denkbar, dass sich die Konzentration der Glaspartikel 16 von der Oberfläche 18 der Schicht 10 bis zum Photovoltaikmodul 12 hin ändert.

Im folgenden soll die Funktionsweise der erfindungsgemäßen Schicht näher erläutert werden.

In der Figur ist ein Lichtstrahl 20 dargestellt, der in einem relativ flachen Winkel auf die Schichtoberfläche 18 fällt. Dort trifft er einen Glaspartikel 16 und wird durch diesen nach unten hin in Richtung des Photovoltaikmoduls 12 gebrochen. Nach dem Austritt aus diesem ersten oberen Glaspartikel 16 durchquert der Lichtstrahl 20 eine Strecke in der Polymermasse und trifft auf seinem Weg auf einen weiteren tiefer liegenden Glaspartikel 16, wird durch diesen weiter nach unten gebrochen, und so fort. Es findet also eine Weiterleitung des Lichtstrahls 20 nach unten zum Photovoltaikmodul 12 statt, die durch die flache Form und die Ausrichtung der Glaspartikel 16 im wesentlichen parallel zur Schichtoberfläche 18 begünstigt wird. Auch in einem sehr flachen Winkel einfallendes Licht wird somit durch die Glaspartikel 16 an der Schichtoberfläche 18 zum Photovoltaikmodul 12 gebrochen bzw. gestreut. Dies ist ein wesentlicher Unterschied gegenüber herkömmlichen Beschichtungen von Photovoltaikmodulen, bei welchem bei einem sehr flachen Einfallswinkel des Lichtstrahls 20, wie er hier gezeigt ist, ein hoher Anteil des einfallenden Lichts reflektiert oder nach außen, d.h. vom Photovoltaikmodul 12 weggestreut wird. Da dieses Licht nicht mehr zur Erzeugung von Solarstrom beitragen kann, ist die Effizienz der herkömmlichen Module bei flach einfallendem Licht gering. Durch den erfindungsgemäßen Lichtbrechungseffekt, der durch die Glaspartikel 16 und ihre Ausrichtung erreicht wird, bleibt die Effizienz des Moduls 12 erfindungsgemäß jedoch auch bei sehr flachen Einfallswinkeln des Lichts erhalten.

Die Schicht 10 wird hergestellt, indem flache Glaspartikel 16 in geeigneter Form, Größenverteilung und Konzentration in ein flüssiges Polymer eingebracht werden, beispielsweise durch Mischen. Ferner wird das flüssige Bindemittel in die flüssige Polymermasse eingebracht, welchem die Oberflächenadditive zur Senkung des Oberflächenwiderstands der Glaspartikel 16 zugesetzt sind. Die so entstandene Polymermasse, welche die Glaspartikel 16 und das Bindemittel enthält, wird anschließend auf die Oberfläche 14 des Photovoltaikmoduls 12 gleichmäßig aufgetragen. Dies kann durch Aufsprühen, Aufspritzen oder Aufstreichen mit einer Rakel geschehen. Zur besseren Verteilung der Polymermasse kann die Viskosität des Polymers selbst gering sein, so dass seine Verarbeitung erleichtert wird.

Es ist auch möglich, die Polymermasse mit den Glaspartikeln 16 und dem Bindemittel nicht unmittelbar auf das Photovoltaikmodul 12 aufzubringen, sondern zunächst auf einem anderen flachen Untergrund, damit die Schicht 10 auf diesem aushärten kann und erst anschließend in Form einer Scheibe mit dem Modul 12 verbunden wird, so dass die Schicht 10 auf der Oberfläche 14 des Moduls 12 aufliegt.

## Patentansprüche

1. Schutzschicht für Photovoltaikmodule, **gekennzeichnet durch** eine Schicht (10) aus einem transparenten Polymer, die mit flachen Glaspartikeln (16) durchsetzt ist, welche im wesentlichen parallel zur Schichtoberfläche ausgerichtet sind, wobei dem Polymer ferner ein Bindemittel zugesetzt ist.

2. Schutzschicht gemäß Anspruch 1, **dadurch gekennzeichnet, dass** die Glaspartikel (16) in einer Konzentration von etwa 10 Gewichts-% im Polymer vorhanden sind.

3. Schutzschicht gemäß Anspruch 1 oder 2, **dadurch gekennzeichnet, dass** die Glaspartikel (16) in unterschiedlichen Größen gemäß einer vorgegebenen Größenverteilung im Polymer vorhanden sind.

4. Schutzschicht gemäß einem der vorhergehenden Ansprüche, **dadurch gekennzeichnet, dass** die Glaspartikel (16) eine Dicke von 2 bis 3 µm aufweisen.

5. Schutzschicht gemäß einem der vorhergehenden Ansprüche, **dadurch gekennzeichnet, dass** das Bindemittel ein einkomponentiges flüssigkeitshärtendes Isocyanat ist, dem Oberflächenadditive zur Senkung des Oberflächenwiderstands der Glaspartikel (16) zugesetzt sind.

6. Verfahren zur Herstellung einer Schutzschicht (10) für Photovoltaikmodule gemäß einem der vorhergehenden Ansprüche, **gekennzeichnet durch** die folgenden Schritte:
a) Bereitstellung eines flüssigen aushärtbaren Polymers, das zumindest in ausgehärteter Form transparent ist,
b) Einbringen flacher Glaspartikel (16) in das flüssige Polymer,
c) Einbringen eines flüssigen Bindemittels, dem Oberflächenadditive zur Senkung des Oberflächenwiderstands der Glaspartikel (16) zugesetzt sind, in das flüssige Poly mer,
d) Auftragen der **durch** die Schritte a), b) und c) hergestellten Polymermasse auf einen Untergrund zur Bildung einer Schicht (10),
e) Aushärten der Schicht (10).

7. Verfahren gemäß Anspruch 6, **dadurch gekennzeichnet, dass** in Schritt d) die Polymermasse auf die Oberfläche eines Photovoltaikmoduls (12) aufgetragen wird.

8. Verfahren gemäß Anspruch 6 oder 7, **dadurch gekennzeichnet, dass** in Schritt d) die Polymermasse durch Aufsprühen oder Aufspritzen aufgetragen wird.

9. Verfahren gemäß Anspruch 6 oder 7, **dadurch gekennzeichnet, dass** in Schritt d) die Polymermasse durch Aufstreichen aufgetragen wird.

10. Verfahren gemäß einem der Ansprüche 6 bis 9, **dadurch gekennzeichnet, dass** in Schritt d) die Glaspartikel (16) in einer Konzentration von etwa 10 Gewichts-% in das flüssige Polymer eingebracht werden.

11. Verfahren gemäß einem der Ansprüche 6 bis 10, **dadurch gekennzeichnet, dass** in Schritt d) Glaspartikel (16) in unterschiedlichen Größen gemäß einer vorgegebenen Größenverteilung in das flüssige Polymer eingebracht werden.

12. Verfahren gemäß einem der Ansprüche 6 bis 11, **dadurch gekennzeichnet, dass** in Schritt d) Glaspartikel (16) mit einer Dicke von 2 bis 3 µm in das flüssige Polymer eingebracht werden.

13. Verfahren gemäß einem der Ansprüche 6 bis 12, **dadurch gekennzeichnet, dass** in Schritt c) als Bindemittel ein einkomponentiges flüssigkeitshärtendes Isocyanat eingebracht wird, dem Oberflächenadditive zur Senkung des Oberflächenwiderstands der Glaspartikel (16) zugesetzt sind.
